(19) Europäisches Patentamt
European Patent Office
Office européen des brevets

(11) **EP 4 760 390 A1**

(12) **EUROPEAN PATENT APPLICATION**
published in accordance with Art. 153(4) EPC

(43) Date of publication:
**17.06.2026 Bulletin 2026/25**

(21) Application number: **24907459.2**

(22) Date of filing: **18.12.2024**

(51) International Patent Classification (IPC):
**G03F 1/62** (2012.01)　　　**G03F 1/66** (2012.01)

(52) Cooperative Patent Classification (CPC):
**G03F 1/62; G03F 1/66**

(86) International application number:
**PCT/JP2024/044812**

(87) International publication number:
**WO 2025/135075 (26.06.2025 Gazette 2025/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.12.2023　JP 2023217220**

(71) Applicant: **Mitsui Chemicals, Inc.**
**Tokyo 104-0028 (JP)**

(72) Inventors:
• **ISHIKAWA, Akira**
**Tokyo 104-0028 (JP)**
• **ONO, Yosuke**
**Tokyo 104-0028 (JP)**
• **OKUBO, Atsushi**
**Tokyo 104-0028 (JP)**

(74) Representative: **Hoffmann Eitle**
**Patent- und Rechtsanwälte PartmbB**
**Arabellastraße 30**
**81925 München (DE)**

(54) **METHOD FOR MANAGING CARBON NANOTUBE PELLICLE MEMBRANE, DEVICE FOR MANAGING CARBON NANOTUBE PELLICLE MEMBRANE, AND PELLICLE CASE**

(57)　A method for managing a CNT pellicle membrane, comprising: upon use of the CNT pellicle membrane, acquiring individual information of the CNT pellicle membrane from an individual information storage unit in which the individual information of the CNT pellicle membrane is recorded, and acquiring storage information of the CNT pellicle membrane from a storage information storage unit in which the storage information of the CNT pellicle membrane is recorded, and identifying cleaning processing conditions of the CNT pellicle membrane from the acquired individual information and the acquired storage information.

FIG.6

START

ACQUIRE INDIVIDUAL INFORMATION — S10

ACQUIRE STORAGE INFORMATION — S20

CALCULATE AVOIDANCE SUBSTANCE EVALUATION VALUE — S30

USABLE? — S40 — N

Y

CALCULATE STORAGE INFORMATION EVALUATION VALUE — S50

USABLE? — S60 — N

Y

IDENTIFY CLEANING PROCESSING CONDITIONS — S70

(DISCARD PELLICLE) — S100

(CLEANING PROCESSING) — S80

USE DIFFERENT PELLICLE? — S110 — Y

N

UPDATE STORAGE INFORMATION — S90

END

EP 4 760 390 A1

**Description**

Technical Field

The present disclosure relates to a method for managing a carbon nanotube pellicle membrane, a device for managing a carbon nanotube pellicle membrane, and a pellicle case.

Background Art

Semiconductor device fabrication processes include lithographic processes for forming a pattern by irradiating light onto a semiconductor wafer. In lithographic processes, for example, light (also called exposure light) is irradiated onto a rectangular shaped photomask substrate formed with the pattern, the exposure light transmitted through the photomask substrate is formed as an image on a wafer, and a resist agent on the wafer is sensitized. A specific pattern is thereby transferred to the wafer.

In lithographic processes, a pellicle is employed to prevent foreign matter from adhering to the pattern formed on the photomask substrate. The pellicle is stuck onto the photomask substrate, and surrounds the pattern formed on the photomask substrate. Normally the pellicle includes a pellicle frame, and a pellicle membrane. The pellicle frame is arranged so as to surround the outside of a pattern area formed on the photomask substrate. The pellicle membrane is stretched over the pellicle frame.

Recently, pellicles that include a carbon nanotube membrane (hereafter referred to as a "CNT membrane") as a pellicle membrane are being investigated. A CNT membrane is readily able to adsorb gas (for example, air) in the peripheral environment. It has become known that, when gas is adsorbed on a CNT membrane, characteristics of the CNT membrane (for example, transmittance to EUV light) are changed from the characteristics immediately after manufacture of the CNT membrane. When the characteristics of the CNT membrane are changed greatly from the characteristics immediately after manufacture of the CNT membrane, then there is a concern that the CNT membrane might affect the pattern being formed on the semiconductor wafer.

Patent Document 1 discloses a case for housing a pellicle (hereafter also sometimes referred to as a "pellicle case"). The pellicle case includes a tray, and a lid that covers the tray. The pellicle case has a tightly sealed structure. The tightly sealed structure seals between a peripheral edge portion of the lid and the tray in a state in which the lid covering the tray is deflected under its own weight. Engineering plastic, reinforced plastic, or metal are disclosed as materials for the lid and tray.

On the other hand, technology to perform cleaning processing according to a state of a CNT pellicle membrane prior to use is disclosed in Non-Patent Document 1. This document describes that hydrocarbons and catalyst particles adsorbed to a CNT pellicle membrane can be removed by heating at 2000 K or less, that a rapid increase in transmittance at a timing when the number of exposures is small can be suppressed, that gas adsorption to a pellicle affects performance, and that the transmittance of the CNT membrane is affected by adjustment of cleaning processing conditions such as heating conditions.

Patent Document 1: Japanese Patent Application Laid-Open (JP-A) No. 2011-79545.

Non-Patent Document 1: M. van de Kerkhofa, A. Klein, B. Seoane, P. Vermeulen, E. Gallagher, M. Y. Timmermans, I. Pollentier & J. Bekaert: "EUV pellicle scanner integration for N2 nodes and beyond", Optical and EUV Nanolithography XXXVI, edited by Anna Lio, Proc. of SPIE, Vol. 12494, 124940D, May 8, 2023 (https://www.spiedigitalli brary.org/conference-proceedings-of-spie).

SUMMARY OF INVENTION

Technical Problem

It is known that characteristics of CNT pellicle membranes are changed when gas present in the peripheral environment is adsorbed. Along with this, it has become known that there is a need to adjust usage conditions and use time, and to change the conditions of cleaning processing as described in Non-Patent Document 1, in accordance with a state of the CNT pellicle membrane prior to use.

A problem addressed by a first aspect of the present disclosure is to provide a CNT pellicle membrane managing method and managing device that enable the identification of appropriate cleaning processing conditions according to individual information and storage information of a CNT pellicle membrane.

A problem addressed by another aspect of the present disclosure is to provide a pellicle case capable of detecting and storing information to identify cleaning processing conditions while storing a CNT pellicle membrane.

Solution to Problem

The following aspects are included in means to address the above problems.

<1> A method for managing a carbon nanotube pellicle membrane, comprising:

upon use of the carbon nanotube pellicle membrane, acquiring individual information of the carbon nanotube pellicle membrane from an individual information storage unit in which the individual information of the carbon nanotube pellicle membrane is recorded, and acquiring storage information of the carbon nanotube pellicle membrane from a storage information storage unit in which the storage information of the carbon nanotube pellicle membrane is recorded; and
identifying cleaning processing conditions of the carbon nanotube pellicle membrane from the acquired individual information and the acquired storage information of the carbon nanotube pellicle membrane.

<2> The method for managing a carbon nanotube pellicle membrane according to <1>, wherein information relating to a membrane thickness of the carbon nanotube pellicle membrane is contained in the individual information.
<3> The method for managing a carbon nanotube pellicle membrane according to <1>, wherein information relating to a post-manufacture storage period and information relating to a storage environment are contained in the storage information.
<4> The method for managing a carbon nanotube pellicle membrane according to <3>, wherein information relating to the storage environment includes information relating to a concentration, in the storage environment, of a substance that is hydrogenated inside a light exposure machine upon use of the carbon nanotube pellicle membrane.
<5> The method for managing a carbon nanotube pellicle membrane according to <3>, wherein the information relating to the storage environment includes information relating to a concentration, in the storage environment, of an avoidance substance whose presence inside a light exposure machine is avoided upon use of the carbon nanotube pellicle membrane.
<6> The method for managing a carbon nanotube pellicle membrane according to <5>, further comprising determining whether or not to use the carbon nanotube pellicle membrane is to be used based on the information relating to the avoidance substance.
<7> The method for managing a carbon nanotube pellicle membrane according to <3>, wherein:

the storage information further includes information relating to a storage period after cleaning processing and information relating to usage conditions of the carbon nanotube pellicle membrane; and
the method further comprises determining whether or not the carbon nanotube pellicle membrane is to be used based on the individual information and the storage information.

<8> A device for managing a carbon nanotube pellicle membrane, comprising:

a pellicle information storage device having an individual information storage unit for storing individual information of a carbon nanotube pellicle membrane, and a storage information storage unit for storing storage information of the carbon nanotube pellicle membrane;
an information acquisition unit for acquiring individual information and storage information of a specific carbon nanotube pellicle membrane from the pellicle information storage device; and
a processing condition identification unit for identifying cleaning processing conditions of the carbon nanotube pellicle membrane from the acquired individual information and the acquired storage information.

<9> A pellicle case comprising:

a casing;
a storage space for storing a carbon nanotube pellicle membrane inside the casing;
a fixing tool for fixing the carbon nanotube pellicle membrane inside the storage space;
an individual information display unit for displaying individual information of the carbon nanotube pellicle membrane; and
a detector for detecting and storing information relating to a storage environment of the carbon nanotube pellicle membrane.

<10> The pellicle according to <9>, wherein the information relating to the storage environment includes information relating to a concentration, in the storage environment, of a substance that is hydrogenated inside a light exposure machine upon use of the carbon nanotube pellicle membrane.

<11> The pellicle case according to <9>, wherein the information relating to the storage environment includes information relating to a concentration, in the storage environment, of an avoidance substance whose presence inside a light exposure machine is avoided upon use of the carbon nanotube pellicle membrane.

Advantageous Effects

One aspect of the present disclosure provides a method and device for managing a CNT pellicle membrane that enable identification of appropriate cleaning processing conditions according to individual information and storage information of the CNT pellicle membrane.

Another aspect of the present disclosure provides a pellicle case capable of detecting and storing information to identify cleaning processing conditions while storing a CNT pellicle membrane.

BRIEF DESCRIPTION OF DRAWINGS

Fig. 1 is an outline of a system in a method for managing a CNT pellicle membrane of an embodiment.

Fig. 2 is a block diagram of a device for managing a CNT pellicle membrane of the embodiment.

Fig. 3 is a first example of a pellicle case of the embodiment.

Fig. 4 is a second example of the pellicle case of the embodiment.

Fig. 5 is a third example of the pellicle case of the embodiment.

Fig. 6 is a flowchart illustrating an outline of the CNT pellicle membrane managing method of the embodiment.

DESCRIPTION OF EMBODIMENTS

Hereinafter, an embodiment of the present disclosure will be described with reference to the drawings. Note that the drawings referred to in the following description are merely schematic, and the sizes, positional relationships, and relative sizes of respective members or portions shown in the drawings do not necessarily reflect actual product conditions. Further, reference numerals that are shown in a plurality of drawings indicate the same configuration or position even if not particularly described in the following description.

In a method for managing a carbon nanotube pellicle membrane (hereafter referred to as "CNT pellicle membrane") of the present disclosure, upon use of the CNT pellicle membrane, individual information of the CNT pellicle membrane is acquired from an individual information storage unit in which individual information of the CNT pellicle membrane is recorded, and storage information of the CNT pellicle membrane is acquired from a storage information storage unit in which storage information of the CNT pellicle membrane is recorded. Cleaning processing conditions of the CNT pellicle membrane are identified from the acquired individual information and the acquired storage information of the CNT pellicle membrane.

The individual information includes individual identification information and individual attribute information. The individual identification information includes, for example, a product number and lot number of the CNT pellicle membrane, a serial number of the pellicle case (described later) in which the CNT pellicle membrane is housed, a product number and serial number of a detector (described later) installed on the pellicle case, and the like. The individual attribute information includes, for example, a brand of the CNT pellicle membrane, a membrane thickness, a type and a thickness of a protective membrane, gas permeability of a pellicle frame, presence or absence of an adhesive on the pellicle, a type of the adhesive, physical property information of the pellicle case, packaging material information including outgas, and the like. This individual information is recorded in an individual information storage unit, described later, at the time of manufacture or shipment of the CNT pellicle membrane.

The storage information includes storage period information, storage environment information, and usage information. The storage period information includes, for example, a post-manufacture storage period of the CNT pellicle membrane, a storage period of the CNT pellicle membrane in the pellicle case, and, when cleaning processing is performed, a storage period before the cleaning processing is performed and a storage period after the cleaning processing is performed. The storage environment information includes, for example, information relating to storage temperature and pressure, information relating to airtightness of the pellicle case, concentration information, in the storage environment, of substances that are hydrogenated inside a light exposure machine upon use of the CNT pellicle membrane (for example, hydrogen-based gases such as hydrogen or water vapor or hydrocarbon gases), and concentration information, in the storage environment, of avoidance substances whose presence in a light exposure machine is avoided (for example, sulfur, phosphorus, fluorine, chlorine, nitrogen, and the like). Whether or not the CNT pellicle membrane is to be used is determined based on the information relating to such avoidance substances. Examples of such avoidance substances include, for example, elements such as Zn, In, Pb, Sn, S, P, Si, F, Cl, Na, Ca, N, Mg, and Mn. Among these, elements such as S ($SO_x$), P ($PO_x$), F ($F_2$), Cl ($Cl_2$), and N ($NH_3$ and $NO_x$), which can be in a gaseous state, are likely to ingress into the pellicle case, and therefore need to be particularly recorded as storage environment information.

Among the storage information, the usage information includes information relating to a storage period after cleaning processing of the CNT pellicle membrane, and information relating to a usage status (for example, exposure time of EUV light, an output of EUV, an atmosphere inside a light exposure machine, and a speed and a number of occurrences of a pressure difference). Whether or not the CNT pellicle membrane is to be used (specifically, whether or not there is remaining usable time and whether or not replacement is necessary) is determined based on the usage information.

Based on the above individual information and storage information, a usable time, a lifespan, and whether or not replacement is necessary of the CNT pellicle membrane are determined, and, if the CNT pellicle membrane is determined to be usable, cleaning processing conditions (for example, a heating time, a heating temperature, and a heating atmosphere including an oxygen concentration, a vacuum level, and a water vapor content) are identified.

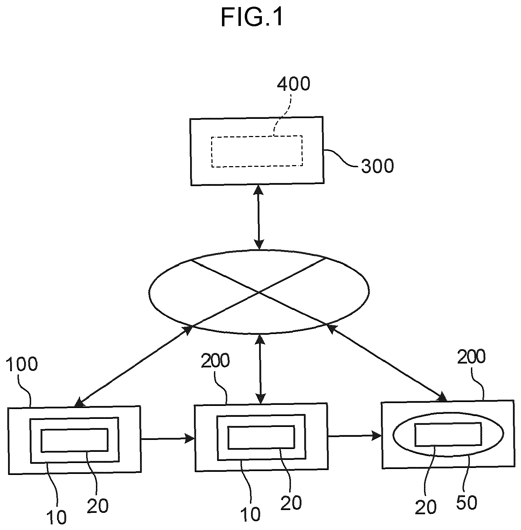

Fig. 1 is an outline of a system in a method for managing a CNT pellicle membrane of the present embodiment. In the present system, a client terminal of a manufacturer 100 and a client terminal of a user 200, are connected to a server 300 via a network. A CNT pellicle membrane management device 400 is provided inside the server 300.

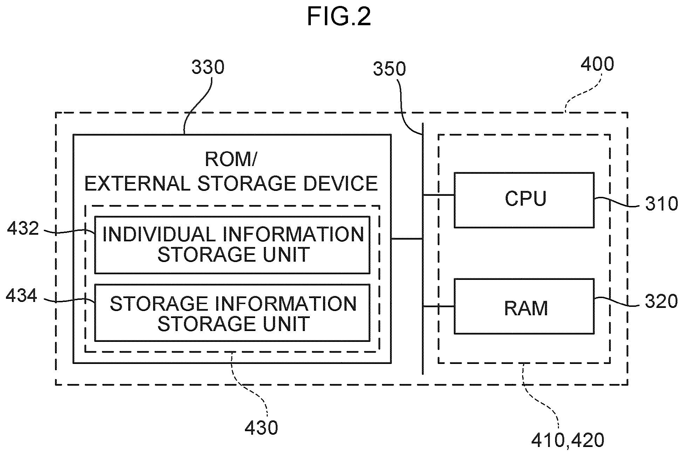

As illustrated in Fig. 2, the management device 400 includes a pellicle information storage device 430 having an individual information storage unit 432 in which individual information of a CNT pellicle membrane is recorded, and a storage information storage unit 434 in which storage information of the CNT pellicle membrane is recorded, an information acquisition unit 410 for acquiring individual information and storage information of a specific CNT pellicle membrane from the pellicle information storage device 430, and a processing condition identification unit 420 for identifying cleaning processing conditions of the CNT pellicle membrane from the acquired individual information and the acquired storage information.

The server 300 illustrated in Fig. 1 includes, as a hardware configuration, a central processing unit (CPU) 310 illustrated in Fig. 2, random access memory (RAM) 320, read-only memory (ROM) and/or an external storage device 330. These components are communicably connected to each other via a bus 350. The pellicle information storage device 430 having the individual information storage unit 432 and storage information storage unit 434 described above is configured as part of the ROM and/or the external storage device 330. The information acquisition unit 410 and the processing condition identification unit 420 are realized by the CPU 310 executing part of a processing program recorded on the ROM and/or the external storage device 330, the part being temporarily deployed in the RAM 320. The information acquisition unit 410, the processing condition identification unit 420, and the pellicle information storage device 430 constitute part of the management device 400.

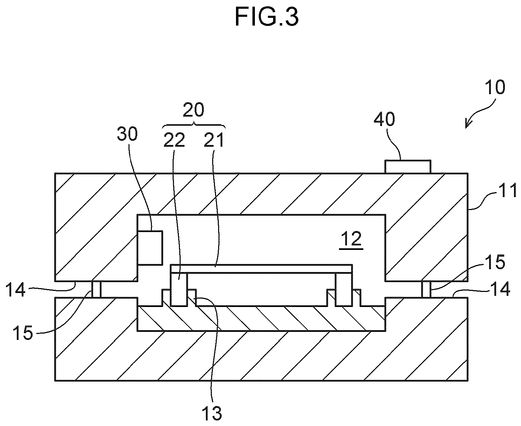

As illustrated in Fig. 1, the manufacturer 100 ships a CNT pellicle membrane 20 to the user 200 in a state in which the CNT pellicle membrane 20 is housed inside a pellicle case 10. At that time, the manufacturer 100 inputs individual information and storage information relating to the CNT pellicle membrane 20 into a terminal on the manufacturer 100 side. The input individual information and storage information are respectively recorded in the individual information storage unit 432 and the storage information storage unit 434 of the management device 400 of the server 300 via the network. Upon use, the user 200 takes the CNT pellicle membrane 20 out of the pellicle case 10, places the CNT pellicle membrane 20 in a cleaning processing machine 50, and executes cleaning processing. As schematically illustrated in the first example of Fig. 3, the pellicle case 10 includes a casing 11, a storage space 12 for storing the CNT pellicle membrane 20 in the casing 11, a fixing tool 13 for fixing the CNT pellicle membrane 20 in the storage space 12, an individual information display unit 40 for displaying individual information of the CNT pellicle membrane 20, and a detector 30 for detecting and storing information relating to a storage environment of the CNT pellicle membrane.

The CNT pellicle membrane 20 may have a structure in which a CNT membrane 21 and a pellicle frame 22 are fixed together by van der Waals force without an adhesive layer interposed, or may have a structure in which the CNT membrane 21 is fixed to the pellicle frame 22 by an adhesive or the like. The individual information display unit 40 is configured to display individual information of the CNT pellicle membrane 20 housed in the pellicle case 10 in a predetermined format (for example, a two-dimensional bar code). The detector 30 is a device for detecting information relating to a storage environment of the CNT pellicle membrane 20, and more specifically, information relating to a concentration, in the storage environment, of substances that are hydrogenated inside a light exposure machine upon use of the CNT pellicle membrane 20, and/or information relating to a concentration, in the storage environment, of avoidance substances whose presence inside a light exposure machine is avoided upon use of the CNT pellicle membrane 20. The detector 30 may be constituted by, for example, a gas detection device capable of storing and displaying concentrations of detected gases.

The storage space 12, which is an internal space of the casing 11, is in communication with an external environment through a ventilation path 14 in order to prevent damage to the CNT pellicle membrane 20 caused by a pressure difference between the storage space 12 and the external environment. A filter 15 is installed in the ventilation path 14 to prevent ingress of foreign matter such as dust from the external environment.

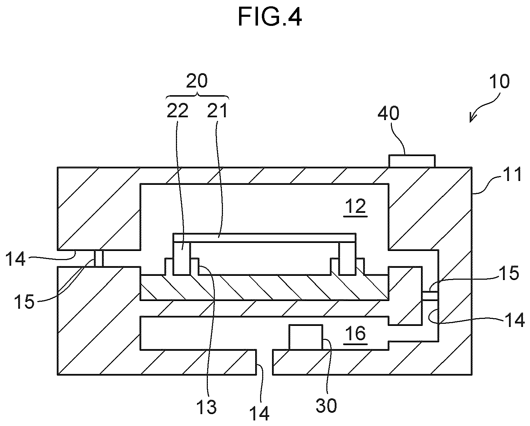

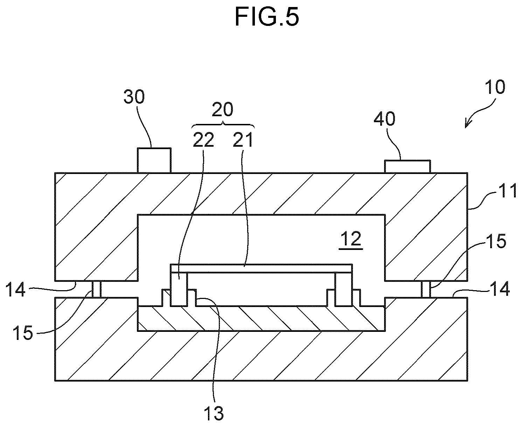

In the first example illustrated in Fig. 3, the detector 30 is provided in the storage space 12; however, the present disclosure is not limited thereto. Specifically, in the second example illustrated in Fig. 4, a detector housing space 16 for housing the detector 30 is provided on the ventilation path 14 on a side closer to the external environment than a position at which the filter 15 is provided. Further, when the storage space 12 is in communication with the external environment, the detector 30 may be provided outside the casing 11, as illustrated in the third example of Fig. 5.

As illustrated in Fig. 1, at the time of shipment of the CNT pellicle membrane 20, the manufacturer 100 attaches individual information of the CNT pellicle membrane 20 to a surface of the pellicle case 10 as the individual information display unit 40. This individual information is recorded in the individual information storage unit 432 (see Fig. 2) as a data table, for example, as shown in Table 1 below.

Table 1

| i | Characteristic Item | Coefficient | Score | | | | | |
|---|---|---|---|---|---|---|---|---|
| 1 | EUV Transmittance (T: %) | $a_1$ | Evaluation Basis | $t_1 \le T$ | $t_2 \le T < t_1$ | $t_3 \le T < t_2$ | $t_4 \le T < t_3$ | $T < t_4$ |
| | | | $x_1$ | 0 | 1 | 2 | 3 | 4 |
| 2 | CNT Brand | $a_2$ | Evaluation Basis | A | B | C | D | E |
| | | | $x_2$ | 0 | 0 | 1 | 1 | 2 |
| 3 | CNT membrane thickness (M: nm) | $a_3$ | Evaluation Basis | $M < m_1$ | $m_1 \le M < m_2$ | $m_2 \le M < m_3$ | $m_3 \le M < m_4$ | $m_4 \le M$ |
| | | | $x_3$ | 0 | 1 | 2 | 3 | 4 |
| ... | ... | ... | ... | ... | ... | ... | ... | ... |
| | | | ... | ... | ... | ... | ... | ... |

In the present exemplary embodiment, EUV in Table 1 is an abbreviation for extreme ultraviolet, and refers to ultraviolet light that is irradiated onto a substrate through the CNT pellicle membrane in a light exposure machine during semiconductor lithography, the ultraviolet light having a wavelength of 1 nm or more and 30 nm or less, and preferably 5 nm or more and 13.5 nm or less.

In the present embodiment, as shown in Table 1, EUV transmittance, a CNT Brand, a CNT membrane thickness, and the like are recorded as characteristic items in the individual information storage unit 432. Each of the characteristic items is assigned a score $x_i$ according to conditions and a coefficient $a_i$ representing a weighting of the characteristic item.

EUV transmittance (T) is an index relating to transmittance of the EUV light of the CNT membrane, and higher numerical values represent superior performance. As values of T, for example, numerical values satisfying $t_4 < t_3 < t_2 < t_1$ are set in a range of 63.0 % to 99.9 %, and a score $x_1$ is determined for each numerical range of T shown in Table 1. For CNT brand, a score $x_2$ shown in Table 1 is determined for each brand of the CNT membrane. For the CNT membrane thickness (M), numerical values satisfying $m_1 < m_2 < m_3 < m_4$ are set in a range of 2 nm to 150 nm, and a score $x_3$ is determined for each numerical range of M shown in Table 1.

Characteristic items other than those shown in Table 1 may also be recorded in the individual information storage unit 432. Upon use of the CNT pellicle membrane 20, as illustrated in Fig. 1, the user 200 inputs information displayed by the individual information display unit 40 of the CNT pellicle membrane 20 into a client terminal, and when an inquiry for the individual information is made to the server 300 via a network, a score $x_i$ and a coefficient $a_i$ are identified for all characteristic items shown in Table 1, and a sum of products of the score $x_i$ and the coefficient $a_i$ is calculated as an evaluation value A, as shown in Equation 1 below.

Equation 1

$$A = \sum_{i=1}^{n} (a_i x_i)$$

As shown in Table 2, the storage information storage unit 434 includes, as characteristic items of storage information, storage period information including a storage period ($P_1$), a post-cleaning storage period ($P_2$), and an interval period (E) from a previous use of the pellicle, and storage environment information including gas adsorption amounts ($A_1$ to $A_3$) of various mass numbers. Each of the characteristic items is assigned a score $y_i$ according to conditions and a coefficient $b_i$ representing a weighting of each characteristic item.

Table 2

| i | Characteristic Item | Coefficient | Score | | | | | |
|---|---|---|---|---|---|---|---|---|
| 1 | Storage Period ($P_1$: days) | $b_1$ | Evaluation Basis | $P_1 < p^1_1$ | $p^1_1 \leq P_1 < p^1_2$ | $p^1_2 \leq P_1 < p^1_3$ | $p^1_3 \leq P_1 < p^1_4$ | $p^1_4 \leq P_1$ |
| | | | $y_1$ | 0 | 1 | 2 | 3 | 4 |
| 2 | Post-Cleaning Storage Period ($P_2$: days) | $b_2$ | Evaluation Basis | Unused | $0 < P_2 < p^2_1$ | $p^{2i} \leq P_2 < p^2_2$ | $p^2_2 \leq P_2 < p^2_3$ | $p^2_3 \leq P_2$ |
| | | | $y_2$ | 0 | 1 | 2 | 3 | 4 |
| 3 | Interval Period (I: hours) | $b_3$ | Evaluation Basis | Unused | $0 < I < i_1$ | $i_1 < I < i_2$ | $i_2 < I < i_3$ | $i_3 \leq 1$ |
| | | | $y_3$ | 0 | 1 | 2 | 3 | 4 |
| 4 | Gas Adsorption Amounts ($A_1$: mbar·L/sec) of Mass Numbers 1, 2, 17, 18 | $b_4$ | Evaluation Basis | $A_1 < a^1_1$ | $a^1_1 < A_n \leq a^1_2$ | $a^1_2 < A_n < a^1_3$ | $a^1_3 \leq A_1 < a^1_4$ | $a^1_4 \leq A_1$ |
| | | | y4 | 0 | 1 | 2 | 3 | 4 |
| 5 | Gas Adsorption Amounts of Mass Numbers greater than 45 and $\leq$ 100 ($A_2$: mbar·L/sec) | $b_5$ | Evaluation Basis | $A_2 < a^2_1$ | $a^2_1 < A_2 \leq a^2_2$ | $a^2_2 < A_2 < a^2_3$ | $a^2_3 \leq A_2 < a^2_4$ | $a^2_4 \leq A_2$ |
| | | | $y_5$ | 0 | 1 | 2 | 3 | 4 |
| 6 | Gas Adsorption Amounts ($A_3$: mbar·L/sec) of Mass Numbers greater than 101 | $b_6$ | Evaluation Basis | $A_3 < a^3_1$ | $a^3_1 < A_3 \leq a^3_2$ | $a^3_2 < A_3 < a^3_3$ | $a^3_3 \leq A_3 < a^3_4$ | $a^3_4 \leq A_3$ |
| | | | $y_6$ | 0 | 1 | 2 | 3 | 4 |
| | ... | ... | ... | ... | ... | ... | ... | ... |
| | | | ... | ... | ... | ... | ... | ... |

The storage period ($P_1$) is an index representing the period during which the CNT pellicle membrane 20 is stored in the pellicle case 10 from manufacture of the CNT pellicle membrane 20, and lower numerical values indicate more suitable for use. As values of $P_1$, for example, numerical values satisfying $p^1_1 < p^1_2 < p^1_3 < p^1_4$ are set in a range of 1 day to 600 days, and a score $y_1$ is determined for each numerical range of $P_1$ shown in Table 2. The post-cleaning storage period ($P_2$) is an index representing a storage period after the CNT pellicle membrane 20 has once undergone cleaning processing, and lower numerical values indicate more suitable for use. As values of $P_2$, for example, numerical values satisfying $p^2_1 < p^2_2 < p^2_3$ are set in a range of 1 day to 600 days, and a score $y_2$ is determined for each numerical range of $P_2$ shown in Table 2. For an unused CNT pellicle membrane 20, $y_2 = 0$. The interval period (I) is an index representing a period during which the CNT pellicle membrane 20 is vacuum-stored in a light exposure machine from a previous use, and lower numerical values indicate more suitable for use. As values of I, for example, numerical values satisfying $i_1 < i_2 < i_3$ are set in a range of 24 hours to 240 hours, and a score $y_3$ is determined for each numerical range of I shown in Table 2. For an unused CNT pellicle membrane 20, however, $y_3 = 0$.

The gas adsorption amount ($A_1$) of mass numbers 1, 2, 17, and 18 is an index indicating that lower numerical values are more suitable for use. As values of $A_1$, for example, numerical values satisfying $a^1_1 < a^1_2 < a^1_3 < a^1_4$ are set in a range of $1 \times 10^{-6}$ mbar·L/sec to $1 \times 10^{-3}$ mbar·L/sec, and a score $y_4$ is determined for each numerical range of $A_1$ shown in Table 2. The gas adsorption amounts ($A_2$) of mass numbers greater than 45 and less than or equal to 100 is an index indicating that lower numerical values are more suitable for use. As values of $A_2$, for example, numerical values satisfying $a^2_1 < a^2_2 < a^2_3 < a^2_4$ are set in a range of $1 \times 10^{-8}$ mbar·L/sec to $1 \times 10^{-5}$ mbar·L/sec, and a score $y_5$ is determined for each numerical range of $A_2$ shown in Table 2. The gas adsorption amount ($A_3$) of mass numbers greater than 101 and less than or equal to 200 is an index indicating that lower numerical values are more suitable for use. As values of $A_3$, for example, numerical values satisfying $a^3_1 < a^3_2 < a^3_3 < a^3_4$ are set in a range of $4 \times 10^{-10}$ mbar·L/sec to $4 \times 10^{-7}$ mbar·L/sec, and a score $y_6$ is determined for each numerical range of $A_3$ shown in Table 2. These indices $A_1$ to $A_3$ are numerical values detected by the detector 30 according to an environment in which the pellicle case 10 is placed and are recorded.

Characteristic items other than those shown in Table 2 may also be recorded in the storage information storage unit 434. Upon use of the CNT pellicle membrane 20, as illustrated in Fig. 1, the user 200 inputs information displayed by the individual information display unit 40 of the CNT pellicle membrane 20 and numerical values relating to the indices A1 to A3 indicated by the detector 30 into the client terminal, and when an inquiry for the individual information is made to the server 300 via a network, a score $y_i$ and a coefficient $b_i$ are identified for all the characteristic items shown in Table 2, and a sum of products of the score $y_i$ and the coefficient $b_i$ is calculated as an evaluation value B, as shown in Equation 2 below.

Equation 2

$$B = \sum_{i=1}^{n} (b_i y_i)$$

The storage information storage unit 434 further includes, as characteristic items of storage information, concentrations ($R_1$ to $R_6$) in a storage environment of various avoidance substances as storage environment information, as shown in Table 3. Each of the characteristic items is assigned a score $z_i$ according to conditions and a coefficient $c_i$ representing a weighting of the characteristic item.

Table 3

| $i$ | Characteristic Item | Coefficient | Score | | | | | |
|---|---|---|---|---|---|---|---|---|
| 1 | $SO_x$ ($R_1$: ppm) | $c_1$ | Evaluation Basis | $R_1 < r^1_1$ | $r^1_1 \le R_1 < r^1_2$ | $r^1_2 \le R_1 < r^1_3$ | $r^1_3 \le R_1 < r^1_4$ | $r^1_4 \le R_1$ |
| | | | $z_1$) | 0 | 1 | 2 | 3 | 4 |
| 2 | $NO_x$ ($R_2$: ppm) | $c_2$ | Evaluation Basis | $R_2 < r^2_1$ | $r^2_1 \le R_2 < r^2_2$ | $r^2_2 \le R_2 < r^2_3$ | $r^2_3 \le R_2 < r^2_4$ | $r^2_4 \le R_2$ |
| | | | $z_2$ | 0 | 1 | 2 | 3 | 4 |
| 3 | $NH_3$ ($R_3$: ppm) | $c_3$ | Evaluation Basis | $R_3 < r^3_1$ | $r^3_1 \le R_3 < r^3_2$ | $r^3_2 \le R_3 < r^3_3$ | $r^3_3 \le R_3 < r^3_4$ | $r^5_4 \le R_3$ |
| | | | Z3 | 0 | 1 | 2 | 3 | 4 |
| 4 | $Cl_2$ ($R_4$: ppm) | $c_4$ | Evaluation Basis | $R_4 < r^4_1$ | $r^4_1 \le R_4 < r^4_2$ | $r^4_2 \le R_4 < r^4_3$ | $r^4_3 \le R_4 < r^4_4$ | $r^4_4 \le R_4$ |
| | | | $z_4$ | 0 | 1 | 2 | 3 | 4 |

(continued)

| $i$ | Characteristic Item | Coefficient | Score | | | | | |
|---|---|---|---|---|---|---|---|---|
| 5 | $F_2$ (Rs: ppm) | $c_5$ | Evaluation Basis | $R_5 < r^5_1$ | $r^5_1 \leq R_5 < r^5_2$ | $r^5_2 \leq R_5 < r^5_3$ | $r^5_3 \leq R_5 < r^5_4$ | $r^5_4 \leq R_5$ |
| | | | $z_5$ | 0 | 1 | 2 | 3 | 4 |
| 6 | Phosphorus compounds ($R_6$: ppm) | $c_6$ | Evaluation Basis | $R_6 < r^6_1$ | $r^6_1 \leq R_6 < r^6_2$ | $r^6_2 \leq R_6 < r^6_3$ | $r^6_3 \leq R_6 < r^6_4$ | $r^6_4 \leq R_6$ |
| | | | $z_6$ | 0 | 1 | 2 | 3 | 4 |
| ... | ... | ... | ... | ... | ... | ... | ... | ... |
| | | | ... | ... | ... | ... | ... | ... |

Each of the indices $R_1$ to $R_6$ indicates suitability for use, with lower numerical values being more suitable for use. Index $R_1$ represents $SO_x$ concentration, and numerical values satisfying $r^1_1 < r^1_2 < r^1_3 < r^1_4$ are set in a range of 10 ppb to 100 ppm, and a score $z_1$ is determined for each numerical range of $R_1$ shown in Table 3. Index $R_2$ represents $NO_x$ concentration, and numerical values satisfying $r^2_1 < r^2_2 < r^2_3 < r^2_4$ are set in a range of 0.05 ppm to 500 ppm, and a score $z_2$ is determined for each numerical range of $R_2$ shown in Table 3. Index $R_3$ represents $NH_3$ concentration, and numerical values satisfying $r^3_1 < r^3_2 < r^3_3 < r^3_4$ are set in a range of 0.05 ppm to 500 ppm, and a score $z_3$ is determined for each numerical range of $R_3$ shown in Table 3. Index $R_4$ represents $Cl_2$ concentration, and numerical values satisfying $r^4_1 < r^4_2 < r^4_3 < r^4_4$ are set in a range of 0.05 ppm to 500 ppm, and a score $z_4$ is determined for each numerical range of $R_4$ shown in Table 3. Index $R_5$ represents $F_2$ concentration, and numerical values satisfying $r^5_1 < r^5_2 < r^5_3 < r^5_4$ are set in a range of 0.005 ppm to 50 ppm, and a score $z_5$ is determined for each numerical range of $R_5$ shown in Table 3. Index $R_6$ represents phosphorus compound concentration, and numerical values satisfying $r^6_1 < r^6_2 < r^6_3 < r^6_4$ are set in a range of 0.05 ppm to 500 ppm, and a score $z_6$ is determined for each numerical range of $R_6$ shown in Table 3.

Characteristic items relating to avoidance substances other than those shown in Table 3 may also be recorded in the storage information storage unit 434. Upon use of the CNT pellicle membrane 20, as illustrated in Fig. 1, the user 200 inputs information displayed by the individual information display unit 40 of the CNT pellicle membrane 20 and numerical values relating to the indices $R_1$ to $R_6$ indicated by the detector 30 into a client terminal, and when an inquiry for the individual information is made to the server 300 via a network, a score $z_i$ and a coefficient $c_i$ are identified for all characteristic items shown in Table 3, and a sum of products of the score $z_i$ and the coefficient $c_i$ is calculated as an evaluation value C, as shown in Equation 3 below.

Equation 3

$$C = \sum_{i=1}^{n} (c_i z_i)$$

As illustrated in Fig. 1, when the user 200 takes the CNT pellicle membrane 20 out of the pellicle case 10 and performs cleaning processing using the cleaning processing machine 50, the evaluation values A, B, and C are calculated from the individual information and the storage information obtained through an inquiry to the server 300, as described above. From these evaluation values A, B, and C, whether or not the CNT pellicle membrane 20 is usable and the cleaning processing conditions are identified.

First, as shown in Table 4 below, for example, when the evaluation value C is less than 10, the CNT pellicle membrane 20 is determined to be usable, whereas when the evaluation value C is 10 or more, the CNT pellicle membrane 20 is determined to be unusable.

Table 4

| C < 10 | $10 \leq C$ |
|---|---|
| Usable | Unusable |

Next, as shown in Table 5 below, usability of the CNT pellicle membrane 20 and, when the CNT pellicle membrane 20 is usable, the number of substrates requiring dummy exposure are identified as cleaning processing conditions based on the evaluation values A and B. As either of the evaluation values A and B increases, the cleaning processing conditions of the CNT pellicle membrane 20 become more severe. The CNT pellicle membrane 20 is determined to be unusable when the evaluation value A is 50 or greater, irrespective of the evaluation value B, and when the evaluation value B is 200 or greater, irrespective of the evaluation value A. Note that, in Table 5 below, conditions such as heating temperature, heating atmosphere, heating time, exposure time, exposure time of EUV light and output of EUV, pressure reduction speed in the light exposure machine, and the number of times of insertion in the light exposure machine may be defined as the cleaning processing conditions.

Table 5

| Number of Dummy Exposure Substrates | A < 10 | 10 ≤ A < 20 | 20 ≤ A < 30 | 30 ≤ A < 50 | 50 ≤ A |
|---|---|---|---|---|---|
| B < 50 | 3 | 5 | 7 | 10 | unusable |
| 50 ≤ B < 100 | 5 | 7 | 10 | 13 | unusable |
| 100 ≤ B < 150 | 7 | 10 | 13 | 17 | unusable |
| 150 ≤ B < 200 | 10 | 13 | 17 | 22 | unusable |
| 200 ≤ B | unusable | unusable | unusable | unusable | unusable |

Moreover, as shown in Table 6 below, usability of the CNT pellicle membrane 20 and, when the CNT pellicle membrane 20 is usable, the cleaning temperature and the cleaning time are identified as the cleaning processing conditions based on the evaluation values A and B. As either of the evaluation values A and B increases, the cleaning processing conditions of the CNT pellicle membrane 20 become more severe. The CNT pellicle membrane 20 is determined to be unusable when the evaluation value A is 50 or greater, irrespective of the evaluation value B, and when the evaluation value B is 200 or greater, irrespective of the evaluation value A. Note that, in Table 6 below, conditions such as a heating atmosphere and an atmosphere of cleaning processing may be defined as the cleaning processing conditions.

Table 6

| Cleaning Time at 400°C | A < 10 | 10 ≤ A < 20 | 20 ≤ A < 30 | 30 ≤ A < 50 | 50 ≤ A |
|---|---|---|---|---|---|
| B < 50 | 0.2 | 0.4 | 0.8 | 1 | unusable |
| 50 ≤ B < 100 | 0.4 | 0.8 | 1 | 1.5 | unusable |
| 100 ≤ B < 150 | 0.8 | 1 | 1.5 | 2 | unusable |
| 150 ≤ B < 200 | 1 | 1.5 | 2 | 3 | unusable |
| 200 ≤ B | unusable | unusable | unusable | unusable | unusable |

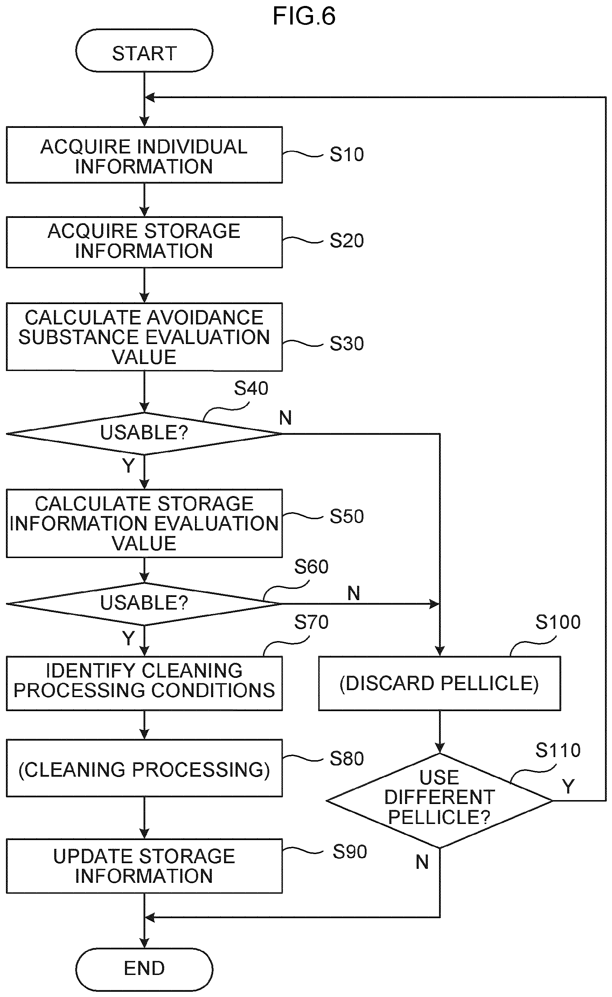

Next, an example of a method for managing a CNT pellicle membrane according to the present disclosure will be described with reference to the flowchart of Fig. 6. Note that the system diagram of Fig. 1 and the block diagram of Fig. 2 may also be referred to as appropriate. In the flowchart of Fig. 6, procedures that are not directly executed by the management device 400 are indicated in parentheses.

First, when the user 200 uses the CNT pellicle membrane 20, as illustrated in Fig. 1, the user 200 inputs information displayed by the individual information display unit 40 of the CNT pellicle membrane 20 and the storage environment information indicated by the detector 30 into the client terminal, and makes an inquiry for the individual information to the server 300 via a network.

Then, at the stage indicated by S10, the information acquisition unit 410 acquires all scores $x_i$ and corresponding coefficients $a_i$ (see Table 1) relating to the individual information of the CNT pellicle membrane 20 from the individual information storage unit 432.

Next, at the stage indicated by S20, the information acquisition unit 410 acquires all scores $y_i$ and $z_i$, and corresponding coefficients $b_i$ and $c_i$ (see Table 2 and Table 3), relating to the storage information of the CNT pellicle membrane 20 from the storage information storage unit 434.

Next, at the stage indicated by S30, the processing condition identification unit 420 calculates the evaluation value C in accordance with Equation 3 from the scores $z_i$ and the coefficients $c_i$ relating to the avoidance substances.

Next, at the stage indicated by S40, whether or not the CNT pellicle membrane 20 is usable is determined by the processing condition identification unit 420 in accordance with the criteria shown in Table 4.

When the processing condition identification unit 420 determines that the CNT pellicle membrane 20 is usable at the stage indicated by S40, then, at the stage indicated by S50, the processing condition identification unit 420 calculates an evaluation value A according to Equation 1 from the scores $x_i$ and the coefficients $a_i$ relating to the individual information, and also calculates an evaluation value B according to Equation 2 from the scores $y_i$ and the coefficients $b_i$ relating to the storage information.

Next, at the stage indicated by S60, whether or not the CNT pellicle membrane 20 is usable is determined by the processing condition identification unit 420 in accordance with the criteria shown in Table 5.

When the processing condition identification unit 420 determines that the CNT pellicle membrane 20 is usable at the stage indicated by S60, then, at the stage indicated by S70, the processing condition identification unit 420 identifies the cleaning processing conditions in accordance with the criteria shown in Table 5 and/or Table 6.

Next, at the stage indicated by S80, the user 200 illustrated in Fig. 1 receives, via the terminal on the user 200 side, the cleaning processing conditions identified by the processing condition identification unit 420 from the server 300 via the network, and executes cleaning processing of the CNT pellicle membrane 20 using the cleaning processing machine 50 in accordance with the cleaning processing conditions.

When the cleaning processing has been completed, at the stage indicated by S90, information associated with the cleaning processing is transmitted from the terminal of the user 200 to the server 300 via the network, and, in the server 300 that has received the information, the storage information recorded in the storage information storage unit 434 is updated by the management device 400, thereby ending the processing.

On the other hand, when the CNT pellicle membrane 20 is determined to be unusable at either the stage indicated by S40 or the stage indicated by S60, the CNT pellicle membrane 20 is discarded at the stage indicated by S100. Then, at the stage indicated by S110, it is determined whether or not to use a different CNT pellicle membrane 20. When it is not used, the processing ends, whereas when it is used, the stages indicated from S10 onwards are repeated for the different CNT pellicle membrane 20.

Industrial Applicability

The present disclosure is applicable to a method for managing a carbon nanotube pellicle membrane, a device for managing a carbon nanotube pellicle membrane, and a pellicle case.

**Claims**

1. A method for managing a carbon nanotube pellicle membrane, comprising:

   upon use of the carbon nanotube pellicle membrane, acquiring individual information of the carbon nanotube pellicle membrane from an individual information storage unit in which the individual information of the carbon nanotube pellicle membrane is recorded, and acquiring storage information of the carbon nanotube pellicle membrane from a storage information storage unit in which the storage information of the carbon nanotube pellicle membrane is recorded, and
   identifying cleaning processing conditions of the carbon nanotube pellicle membrane from the acquired individual information and the acquired storage information of the carbon nanotube pellicle membrane.

2. The method for managing a carbon nanotube pellicle membrane according to claim 1, wherein information relating to a membrane thickness of the carbon nanotube pellicle membrane is contained in the individual information.

3. The method for managing a carbon nanotube pellicle membrane according to claim 1, wherein information relating to a post-manufacture storage period and information relating to a storage environment are contained in the storage information.

4. The method for managing a carbon nanotube pellicle membrane according to claim 3, wherein the information relating to the storage environment includes information relating to a concentration, in the storage environment, of a substance that is hydrogenated inside a light exposure machine upon use of the carbon nanotube pellicle membrane.

5. The method for managing a carbon nanotube pellicle membrane according to claim 3, wherein the information relating to the storage environment includes information relating to a concentration, in the storage environment, of an avoidance substance whose presence inside a light exposure machine is avoided upon use of the carbon nanotube pellicle membrane.

6. The method for managing a carbon nanotube pellicle membrane according to claim 5, further comprising determining whether or not the carbon nanotube pellicle membrane is to be used based on the information relating to the avoidance substance.

7. The method for managing a carbon nanotube pellicle membrane according to claim 3, wherein:

   the storage information further includes information relating to a storage period after cleaning processing and information relating to usage conditions of the carbon nanotube pellicle membrane; and
   the method further comprises determining whether or not the carbon nanotube pellicle membrane is to be used based on the individual information and the storage information.

8. A device for managing a carbon nanotube pellicle membrane, comprising:

   a pellicle information storage device having an individual information storage unit for storing individual information of a carbon nanotube pellicle membrane, and a storage information storage unit for storing storage information of the carbon nanotube pellicle membrane;
   an information acquisition unit for acquiring individual information and storage information of a specific carbon nanotube pellicle membrane from the pellicle information storage device; and
   a processing condition identification unit for identifying cleaning processing conditions of the carbon nanotube pellicle membrane from the acquired individual information and the acquired storage information.

9. A pellicle case comprising:

   a casing;
   a storage space for storing a carbon nanotube pellicle membrane inside the casing;
   a fixing tool for fixing the carbon nanotube pellicle membrane inside the storage space;
   an individual information display unit for displaying individual information of the carbon nanotube pellicle membrane; and
   a detector for detecting and storing information relating to a storage environment of the carbon nanotube pellicle membrane.

10. The pellicle case according to claim 9, wherein the information relating to the storage environment includes information relating to a concentration, in the storage environment, of a substance that is hydrogenated inside a light exposure machine upon use of the carbon nanotube pellicle membrane.

11. The pellicle case according to claim 9, wherein the information relating to the storage environment includes information relating to a concentration, in the storage environment, of an avoidance substance whose presence inside a light exposure machine is avoided upon use of the carbon nanotube pellicle membrane.

# FIG.1

# FIG.2

330   350   400

```
┌─────────────────────────────────────────┐ ┌──────────────────┐
│  ROM/                                     │ │                  │
│  EXTERNAL STORAGE DEVICE                  │ │   ┌──────────┐   │
│   ┌─────────────────────────────────┐    │ │   │   CPU    │───┼─ 310
│432─│  INDIVIDUAL INFORMATION         │    │ │   └──────────┘   │
│   │  STORAGE UNIT                    │    │ │                  │
│   ├─────────────────────────────────┤    │ │   ┌──────────┐   │
│434─│  STORAGE INFORMATION            │    │ │   │   RAM    │───┼─ 320
│   │  STORAGE UNIT                    │    │ │   └──────────┘   │
│   └─────────────────────────────────┘    │ │                  │
└─────────────────────────────────────────┘ └──────────────────┘
```

430

410,420

# FIG.3

# FIG.4

## FIG.5

## FIG.6

```
                    ┌──────────────┐
                    │    START     │
                    └──────┬───────┘
                           │ ◄──────────────────────────────┐
                           ▼                                 │
              ┌──────────────────────┐                       │
              │  ACQUIRE INDIVIDUAL  │── S10                  │
              │     INFORMATION     │                         │
              └──────────┬───────────┘                        │
                         ▼                                    │
              ┌──────────────────────┐                        │
              │   ACQUIRE STORAGE    │── S20                   │
              │     INFORMATION     │                          │
              └──────────┬───────────┘                         │
                         ▼                                     │
              ┌──────────────────────┐                         │
              │ CALCULATE AVOIDANCE  │── S30                    │
              │ SUBSTANCE EVALUATION │                          │
              │        VALUE         │                          │
              └──────────┬───────────┘                          │
                         ▼          S40                         │
                    ◇─────────────◇   N                          │
                    │   USABLE?   │──────────────┐               │
                    ◇─────────────◇              │               │
                         │ Y                     │               │
                         ▼                       │               │
              ┌──────────────────────┐            │               │
              │  CALCULATE STORAGE   │── S50       │               │
              │ INFORMATION EVALUATION│            │               │
              │        VALUE         │             │               │
              └──────────┬───────────┘             │               │
                         ▼          S60            │               │
                    ◇─────────────◇   N            │               │
                    │   USABLE?   │────────────────┤               │
                    ◇─────────────◇                │               │
              S70        │ Y                       │               │
              ┌──────────────────────┐    ┌───────────────────┐     │
              │  IDENTIFY CLEANING   │    │(DISCARD PELLICLE) │ S100│
              │ PROCESSING CONDITIONS│    └─────────┬─────────┘     │
              └──────────┬───────────┘              ▼               │
                         ▼              S80      ◇──────────◇  S110 │
              ┌──────────────────────┐           │   USE    │   Y  │
              │ (CLEANING PROCESSING)│           │DIFFERENT │──────┘
              └──────────┬───────────┘           │ PELLICLE?│
                         ▼                        ◇──────────◇
              ┌──────────────────────┐                │ N
              │   UPDATE STORAGE     │── S90           │
              │     INFORMATION     │                  │
              └──────────┬───────────┘                 │
                         │ ◄───────────────────────────┘
                         ▼
                    ┌──────────────┐
                    │     END      │
                    └──────────────┘
```

## INTERNATIONAL SEARCH REPORT

| International application No. |
|---|
| **PCT/JP2024/044812** |

**A. CLASSIFICATION OF SUBJECT MATTER**

*G03F 1/62*(2012.01)i; *G03F 1/66*(2012.01)i
FI: G03F1/62; G03F1/66

According to International Patent Classification (IPC) or to both national classification and IPC

**B. FIELDS SEARCHED**

Minimum documentation searched (classification system followed by classification symbols)

G03F1/62; G03F1/66

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2023-27129 A (ASML NETHERLANDS B.V.) 01 March 2023 (2023-03-01) paragraphs [0143]-[0146] | 1-11 |
| A | JP 2015-18272 A (ASAHI KASEI E MATERIALS CORP.) 29 January 2015 (2015-01-29) entire text, all drawings | 1-11 |
| A | JP 2022-507168 A (ASML NETHERLANDS B.V.) 18 January 2022 (2022-01-18) entire text, all drawings | 1-11 |

☐ Further documents are listed in the continuation of Box C.    ☑ See patent family annex.

| | |
|---|---|
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **21 January 2025** | **04 February 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/044812**

| Patent document cited in search report | | | Publication date (day/month/year) | Patent family member(s) | | | Publication date (day/month/year) |
|---|---|---|---|---|---|---|---|
| JP | 2023-27129 | A | 01 March 2023 | US paragraphs [0172]-[0175] WO | 2020/0209736 2018/228933 | A1 A2 | |
| JP | 2015-18272 | A | 29 January 2015 | (Family: none) | | | |
| JP | 2022-507168 | A | 18 January 2022 | US entire text, all drawings WO | 2022/0008963 2020/109152 | A1 A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011079545 A

**Non-patent literature cited in the description**

- **M. VAN DE KERKHOFA** ; **A. KLEIN** ; **B. SEOANE** ; **P. VERMEULEN** ; **E. GALLAGHER** ; **M. Y. TIMMER-MANS** ; **I. POLLENTIER** ; **J. BEKAERT**. EUV pellicle scanner integration for N2 nodes and beyond. *Optical and EUV Nanolithography XXXVI*, 08 May 2023, vol. 12494, 124940D, https://www.spiedigitallibrary.org/-conference-proceedings-of-spie